# FASCICULE DE BREVET EUROPEEN

(11) **EP 2 215 488 B1**
(45) Date de publication et mention de la délivrance du brevet: **04.05.2011**
(21) Numéro de dépôt: 08872104.8
(22) Date de dépôt: 14.11.2008
(51) Int. Cl.: G01R 31/02, G01R 31/04

(54) **ENSEMBLE DE DETECTION D'UNE DISCONTINUITE ELECTRIQUE ENTRE UN CONTACT ELECTRIQUE ET UN ELEMENT ELECTRIQUEMENT CONDUCTEUR**
ANORDNUNG ZUR DETEKTION VON ELEKTRISCHER DISKONTINUITÄT ZWISCHEN EINEM ELEKTRISCHEN KONTAKT UND EINEM ELEKTRISCH LEITFÄHIGEN, AUF EINER DETEKTIONSSCHALTUNG MONTIERTEN ELEMENT
ASSEMBLY FOR DETECTING ELECTRIC DISCONTINUITY BETWEEN AN ELECTRIC CONTACT AND AN ELECTRICALLY CONDUCTING MEMBER MOUNTED IN THE DETECTION CIRCUIT

(30) Priorité: 21.11.2007 FR 0708162
(43) Date de publication de la demande: 11.08.2010
(73) Titulaire: Lohr Industrie, 67980 Hangenbieten (FR)
(72) Inventeur: VANAUD, Sébastien, F-67400 Illkirch Graffenstaden (FR)
(74) Mandataire: Metz, Paul
(86) Numéro de dépôt international: PCT/FR2008/001603
(87) Numéro de publication internationale: WO 2009/098373

(56) Documents cités:
- EP-A- 1 538 058
- DE-C- 19 735 282
- FR-A- 2 846 917
- US-A- 4 812 752

## Description

La présente invention se rapporte à un circuit de détection comportant au moins deux contacts électriques distincts normalement en contact avec un élément conducteur commun les reliant, et permettant la détection d'une discontinuité électrique entre l'un de ces contacts électriques et l'élément conducteur.

La présente invention concerne également un ensemble de détection incorporant un tel circuit de détection.

L'invention se rapporte plus particulièrement à un ensemble de détection dans lequel les deux contacts électriques sont mobiles le long d'une masse conductrice formée par exemple par un rail de roulage ou de guidage pour un véhicule terrestre.

Dans de nombreux domaines, par exemple dans celui des véhicules, du transport de marchandises, de la manutention ou du stockage, il est utile de savoir en temps réel si deux éléments se trouvent en contact.

Dans ces domaines, il faut souvent s'assurer que certains éléments qui doivent rester en contact l'un avec l'autre, mais qui ne sont pas fixés l'un à l'autre afin par exemple de pouvoir se déplacer ou être déplaçables, le sont effectivement en permanence.

En effet, deux éléments devant être en contact l'un avec l'autre en conditions normales de fonctionnement ou d'utilisation, peuvent être involontairement ou accidentellement séparés du fait d'une situation anormale et/ou imprévisible. Il est alors très important et très utile, par exemple pour des raisons de sécurité ou pour éviter un dysfonctionnement, de détecter cette situation en temps réel afin de pouvoir sans délais engager des actions correctives ou déclencher des mesures de sécurité.

L'ensemble de détection selon l'invention permet de répondre à un tel besoin en utilisant le caractère électriquement conducteur des deux éléments dont le contact est à surveiller.

A titre d'exemple, on peut citer l'application préférentielle de véhicules guidés au moyen d'un système de guidage coulissant le long d'au moins un rail de guidage. Il peut s'agir notamment d'un véhicule urbain de transport en commun de passagers, de chariots industriels éventuellement automatisés ou encore par exemple de véhicules de manutention.

Dans ce cas, il est absolument indispensable de s'assurer que le système de guidage est en permanence en contact avec le rail de guidage afin de détecter et d'éviter tout risque de déraillement, par exemple en cas d'interruption localisée du rail de guidage, de présence d'un obstacle ou d'un objet imprévu sur ou le long du rail de guidage, de gel ou de tout autre cause pouvant provoquer la levée accidentelle du système de guidage.

La présente invention pourra être utilisée pour surveiller le contact entre le système de guidage et le rail de guidage, plus particulièrement entre deux contacts électriques du système de guidage et le rail de guidage métallique par lequel ils sont reliés.

De tels véhicules sont parfois pourvus d'un dispositif de sécurité placé avant l'ensemble de guidage et dont le rôle est de palper le rail de guidage avant le passage de l'ensemble de guidage afin de s'assurer légèrement à l'avance de l'état satisfaisant et dégagé du rail de guidage et de son environnement proche. L'ensemble de détection selon l'invention pourra alors avantageusement être utilisé à ce niveau afin de surveiller le contact entre le dispositif de sécurité et le rail de guidage.

On peut également envisager d'utiliser l'ensemble de détection selon l'invention pour surveiller des éléments devant rester en contact avec un rail de roulage.

Le domaine d'application de la présente invention n'est cependant pas limité au cas des véhicules mobiles le long d'un ou de plusieurs rails de guidage ou de roulage et peut s'étendre à de nombreux autres cas.

Ainsi par exemple, un tel ensemble de détection pourra avantageusement permettre de surveiller le contact entre les pieds d'un conteneur, d'une caisse, d'un réservoir ou autre, et le support sur lequel il est posé afin par exemple de sécuriser son transport, sa manutention ou son stockage.

Pour cela, le conteneur est équipé de pieds ou d'au moins deux zones de contact distinctes métalliques. De même, le support doit être électriquement conducteur entre ces deux zones de contact et peut dans ce but être totalement ou partiellement métallique, être recouvert d'un revêtement électriquement conducteur ou d'une simple bande de liaison électrique.

De nombreuses autres applications de l'ensemble de détection selon l'invention pourront être imaginées sans difficultés par l'homme du métier.

L'invention concerne un ensemble de détection comprenant deux contacts électriques, ou deux zones de contact électrique, reliés par une masse ou un élément électriquement conducteur ou faiblement résistif.

Pour détecter une absence de contact entre l'un au moins des deux contacts électriques et l'élément conducteur avec lequel il est censé être en contact, on cherche à détecter un défaut de continuité électrique entre les deux contacts reliés entre eux par l'élément électriquement conducteur.

La présente invention fournit ainsi un ensemble de détection d'une discontinuité électrique entre un contact électrique et un élément électriquement conducteur, cet ensemble comprenant deux contacts électriques distincts et un élément électriquement conducteur les reliant avec lequel les contacts électriques se trouvent normalement en contact.

Selon l'invention, l'ensemble de détection comprend un excitateur comportant comme charge un circuit résonnant, ce circuit résonnant comprenant en partant d'une des bornes de l'excitateur pour revenir à son autre borne, au moins un condensateur, l'un des contacts électriques, une partie d'impédance variable selon l'état ouvert ou fermé d'au moins l'un des contacts et le deuxième contact électrique.

La partie d'impédance variable comprend, en situation normale de contact, une première branche résistive et selfique formée par l'élément conducteur et au moins une deuxième branche résistive et selfique, montée en parallèle et formée par une liaison électrique constructive reliant les deux contacts. La première branche est mise hors circuit à l'ouverture d'au moins l'un des contacts.

L'ensemble de détection comporte en outre un module électronique de traitement qui reçoit la fréquence d'oscillation du circuit résonnant et la convertit en un signal de défaut exploitable en cas de discontinuité électrique.

En ce qui concerne les deux branches parallèles de la partie d'impédance variable, on utilise préférentiellement les caractéristiques de résistance électrique et les effets selfiques inhérents d'une part à l'élément conducteur pour l'une des branches et d'autre part à la liaison électrique de nature quelconque existant entre les contacts en plus et indépendamment de l'élément conducteur, pour l'autre branche.

Lorsque les effets résistifs et selfiques naturels de ces liaisons sont trop faibles pour pouvoir être exploités de façon satisfaisante dans le circuit de détection de l'invention, il est possible de rajouter des composants électriques résistifs et/ou selfiques supplémentaires afin d'amplifier l'effet souhaité.

De même, si dans l'application concernée, il n'existe pas de liaison électrique entre les contacts à part l'élément conducteur, les contacts sont alors reliés par une liaison électrique filaire ou de nature appropriée quelconque.

L'invention fournit un ensemble de détection complet qui intègre un circuit de détection et comporte en outre un module électronique de traitement permettant de convertir les variations résultant du circuit de détection en un signal de détection et de fournir en sortie une information exploitable sur l'état électrique des contacts surveillés.

Cette information peut ensuite être envoyée vers un système d'alarme sonore ou visuel, ou peut être exploitée par un système général de surveillance ou de gestion capable de déclencher des mesures de sécurité adaptées.

Dans l'art antérieur, de nombreux circuits de détection ont été décrits, comme par exemple les circuits divulgués dans les brevets DE 197 35 282 au nom de SEKURIT SAINT GOBAIN et US-A-4.812.752 au nom de PREUS. Cependant, ces circuits sont très différents de l'ensemble de détection de l'invention et ne permettent pas de résoudre le problème technique.

D'autres caractéristiques et avantages de l'invention apparaîtront dans la description qui suit, donnée à titre d'exemple et accompagnée des dessins dans lesquels :
- la figure 1 est un schéma général fonctionnel d'un ensemble de détection selon l'invention appliqué à deux zones de contact quelconque ;
- la figure 2 est un schéma par blocs d'un circuit de détection selon l'invention ;
- la figure 3 est un graphique représentant une forme d'onde illustrant la variation de fréquence du circuit de détection résultant de l'absence de contact électrique ;
- la figure 4 est un exemple de schéma électrique de l'ensemble de détection selon l'invention ;
- la figure 5 est le schéma électrique général d'une variante s'appliquant aux patins frotteurs d'un véhicule, se déplaçant le long d'un rail métallique de guidage.

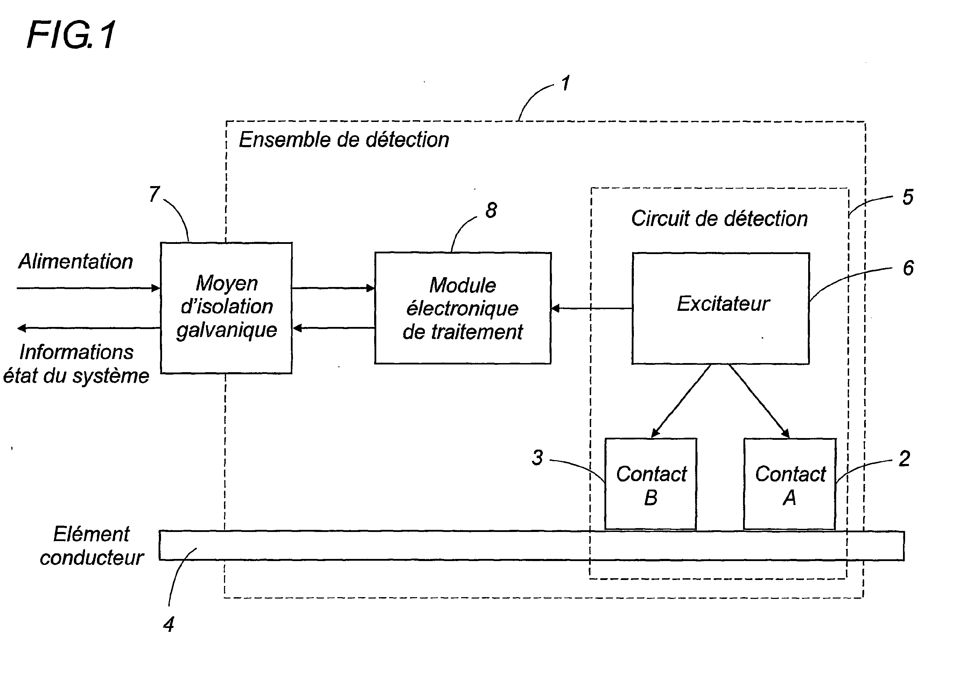

Afin de permettre au lecteur de bien comprendre l'invention, on a représenté sur la figure 1 le schéma général fonctionnel global d'un ensemble de détection 1 selon l'invention.

Cet ensemble de détection 1 permet de surveiller l'existence d'un contact entre un couple de contacts électriques 2 et 3, respectivement dénommés contact A et contact B sur les figures, et un élément conducteur 4 avec lequel ils sont censés rester en contact.

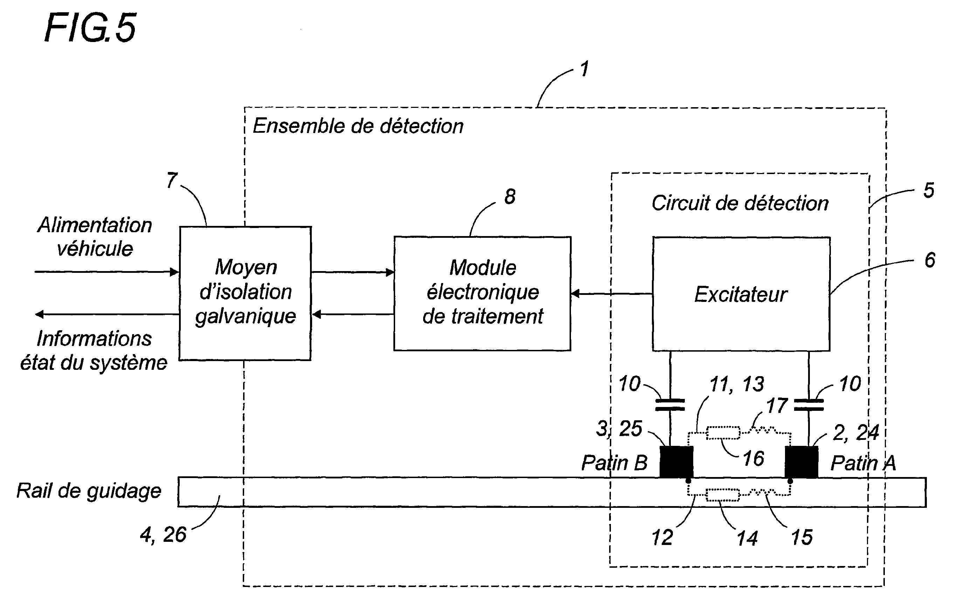

Les contacts électriques 2 et 3 peuvent être fixes ou mobiles et de nature et d'étendue quelconques. Selon une application préférentielle représentée sur la figure 5, il peut s'agir par exemple à chaque fois d'un patin coulissant le long d'un rail métallique de roulage ou de guidage. Il peut s'agir également de pieds ou de zones de contacts devant reposer sur un support conducteur ou sur des zones réceptrices conductrices d'un support.

L'élément conducteur 4 établit une liaison électrique entre les contacts A et B lorsque ceux-ci sont tous deux en contact avec lui.

L'élément conducteur 4 peut être de nature quelconque. Il peut s'agir par exemple d'une masse, d'un profilé ou d'un revêtement métallique. Il peut s'agir encore d'une simple liaison filaire reliant deux zones réceptrices conductrices destinées à recevoir les contacts A et B, ou de tout autre élément conducteur approprié imaginable par l'homme du métier en fonction de l'application envisagée pour l'ensemble de détection 1 selon l'invention.

Pour connaître l'état électrique ouvert ou fermé des contacts 2 et 3 par rapport à l'élément conducteur 4, c'est-à-dire savoir s'ils sont ou non en contact électrique avec celui-ci, on utilise un circuit de détection 5.

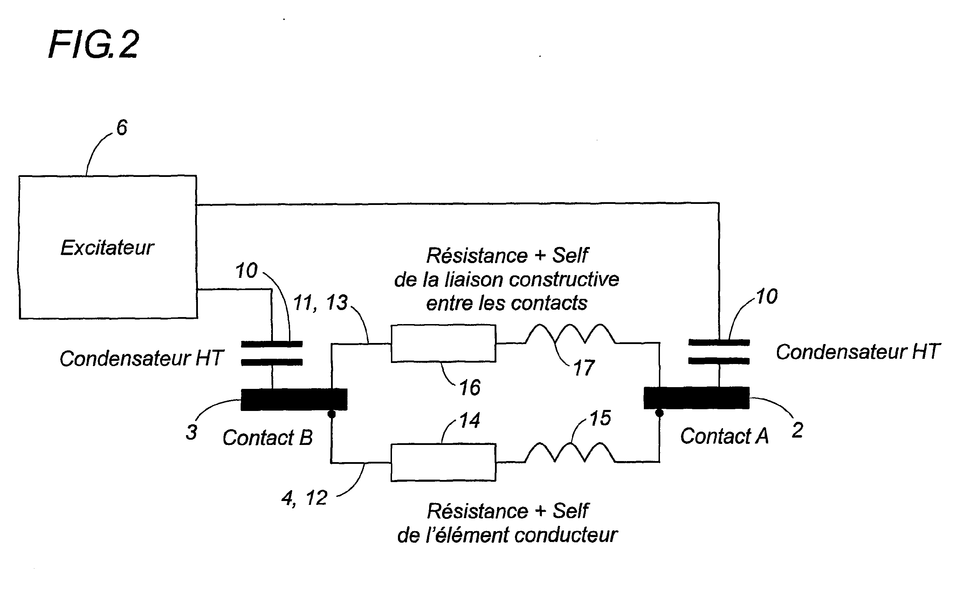

Ce circuit de détection 5, dont le fonctionnement sera étudié plus en détail en référence à la figure 2, forme une boucle de référence au sein de l'ensemble de détection 1 et comprend un dispositif d'excitation électrique appelé excitateur 6 relié aux contacts A et B, à travers un ou plusieurs condensateurs.

L'excitateur 6 est un élément générateur d'énergie pour un circuit résonnant. Il s'agit par exemple d'un composant électronique ou d'un montage à amplificateur opérationnel astable ou tout autre générateur.

Dans cette boucle, l'élément conducteur 4 peut représenter la terre du point de vue électrique.

L'énergie d'alimentation, nécessaire au fonctionnement de l'ensemble de détection 1, provient de l'extérieur et doit être de préférence électriquement isolée de la terre et donc de l'élément conducteur 4. L'ensemble de détection 1 est ainsi préférentiellement isolé par un moyen d'isolation galvanique 7.

L'ensemble de détection 1 comprend également un module électronique de traitement 8 qui convertit les variations de fréquence d'oscillation provenant du circuit de détection 5 en un signal de défaut exploitable.

Comme on le verra par la suite, les fréquences d'oscillation du circuit de détection 5 sont différentes selon que les contacts A et B se trouvent en liaison électrique avec l'élément conducteur 4 ou que cette liaison est interrompue du fait de l'ouverture ou décollement de l'un au moins des contacts A ou B ou en raison d'un défaut de la portion de l'élément conducteur 4 comprise entre les deux contacts A et B.

Selon les différences entre les valeurs des fréquences du circuit de détection 5, le module électronique de traitement 8 délivre vers l'extérieur une information exploitable, représentative de l'état électrique de l'un au moins des contacts.

Cette information peut ensuite être utilisée de différentes façons selon l'application visée. Elle peut par exemple être envoyée vers un système d'alarme sonore ou visuel, ou vers un système général de gestion pouvant, le cas échéant, déclencher des actions correctives ou de sécurité.

La fonction de détection résulte du circuit de détection 5 dont le fonctionnement électrique a été schématisé sur la figure 2.

L'excitateur 6 est, de préférence, un dispositif d'excitation électrique se présentant sous la forme d'un composant ou d'un montage électrique apporteur périodique d'énergie, dont chacune des bornes de sortie est reliée à l'un des contacts A ou B, à travers au moins un condensateur 10.

Sur l'exemple préférentiel représenté, le circuit de détection 5 comporte un condensateur 10 intercalé entre chaque borne de l'excitateur 6 et le contact électrique 2 ou 3 correspondant.

Ces condensateurs 10 permettent d'éviter qu'une tension continue pouvant éventuellement provenir de l'élément conducteur 4 ne soit transmise à l'excitateur 6 et surtout au module électronique de traitement 8. Le module électronique de traitement 8 est ainsi isolé du potentiel continu éventuel des contacts A et B.

En situation normale de fonctionnement, les contacts A et B sont électriquement reliés entre eux de deux façons : par l'intermédiaire de l'élément conducteur 4 et par une liaison constructive 11. Ces deux liaisons forment respectivement une première branche 12 et une deuxième branche 13 d'un montage à deux branches parallèles fermant la boucle du circuit de détection 5.

La liaison constructive 11 est une liaison électrique qui peut être réalisée de n'importe quelle façon. Il peut s'agir par exemple d'une liaison structurelle par le châssis, le bâti, ou d'autres éléments de l'objet sur lequel sont montés les contacts 2 et 3. Il peut s'agir également d'une liaison spécifique, de nature filaire ou autre, uniquement utilisée dans le circuit de détection 5 selon l'invention ou présentant une ou plusieurs autres fonctions quelconques.

Si dans l'application visée une telle liaison électrique n'existe pas entre les contacts 2 et 3, une liaison constructive 11 spécifique doit être rajoutée entre les contacts afin d'assurer un bon fonctionnement de l'ensemble de détection 1.

Chacune des branches 12 et 13 parallèles du circuit de détection 5 présente des caractéristiques résistives et selfiques inhérentes, symbolisées sur la figure 2 par, et équivalentes à, une résistance électrique et une self, respectivement 14 et 15 pour la première branche 12 et 16 et 17 pour la deuxième branche, associées en série.

Ce montage à deux branches parallèles constitue une partie de la charge de l'excitateur 6 en situation normale de fonctionnement, c'est-à-dire lorsque les contacts A et B sont tous les deux en contact avec l'élément conducteur 4. L'autre partie de la charge est constituée par les deux liaisons contenant éventuellement un condensateur 10. On a formé alors avec l'excitateur 6 un circuit oscillant à partie résonnante RLC qui présente une fréquence d'oscillation propre appelée fréquence de contact F_{c}.

Lorsque l'un au moins des contacts A ou B ne se trouve plus en contact électrique avec l'élément conducteur 4, la première branche 12 du montage se trouve hors circuit. Les contacts A et B ne sont alors plus reliés que par la liaison constructive 11 formant la deuxième branche 13 du montage.

La charge de l'excitateur 6 est modifiée et équivalente à un circuit résonnant RLC dont les valeurs résistive et selfique sont différentes. La fréquence d'oscillation du circuit résonnant change et devient une fréquence appelée fréquence de décollement F_{D} plus faible.

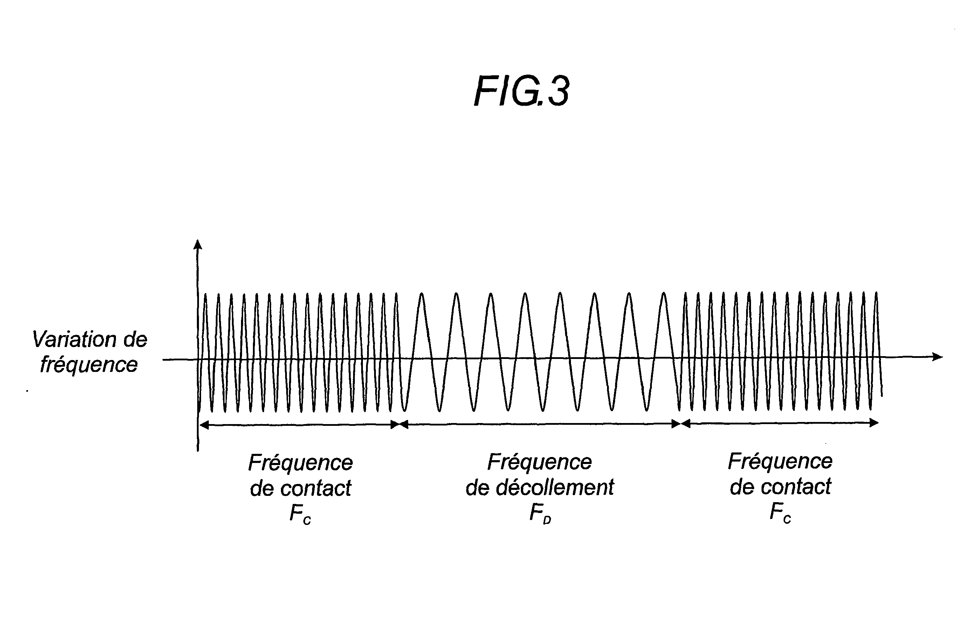

Un exemple d'une telle variation de fréquence d'oscillation a été illustré par la figure 3.

Les valeurs des fréquences d'oscillation F_{C} et F_{D} du circuit résonnant dépendent des valeurs résistives et selfiques des deux branches 12 et 13.

On peut citer à titre d'exemple, dans le cas d'une application de l'ensemble de détection selon l'invention à un véhicule autoguidé sur un rail conducteur, une fréquence F_{C} de préférence sensiblement égale à 5 MHz et une fréquence F_{D} de préférence sensiblement égale à 4 MHz.

Lorsque les effets résistifs et selfiques naturels des liaisons électriques formant les branches 12 et 13 sont trop faibles pour pouvoir être exploités de façon satisfaisante dans le circuit de détection 5 de l'invention, il est possible de rajouter un ou plusieurs composants électriques résistifs et/ou selfiques supplémentaires afin d'amplifier l'effet souhaité.

Une branche supplémentaire comprenant une résistance seule ou une self seule ou les deux composants montés en série, peut alors être montée en parallèle sur la première branche 12 et/ou sur la deuxième branche 13.

Avantageusement, le circuit de détection 5 selon l'invention permet de détecter le décollement de chacun des contacts 2 ou 3, indépendamment de l'état de l'autre. Il n'est donc pas nécessaire que les deux contacts soient décollés pour que le circuit détecte un défaut. De même, le circuit de détection 5 peut détecter une interruption du circuit électrique entre les deux contacts 2 et 3, c'est-à-dire un défaut de la portion de l'élément conducteur 4 située entre ceux-ci.

Cette variation de la fréquence d'oscillation du circuit résonnant est exploitée par le module électronique de traitement 8 afin de la transformer en un signal de défaut S_{D} utilisable par la suite, par exemple par un système de surveillance, de gestion ou d'alarme.

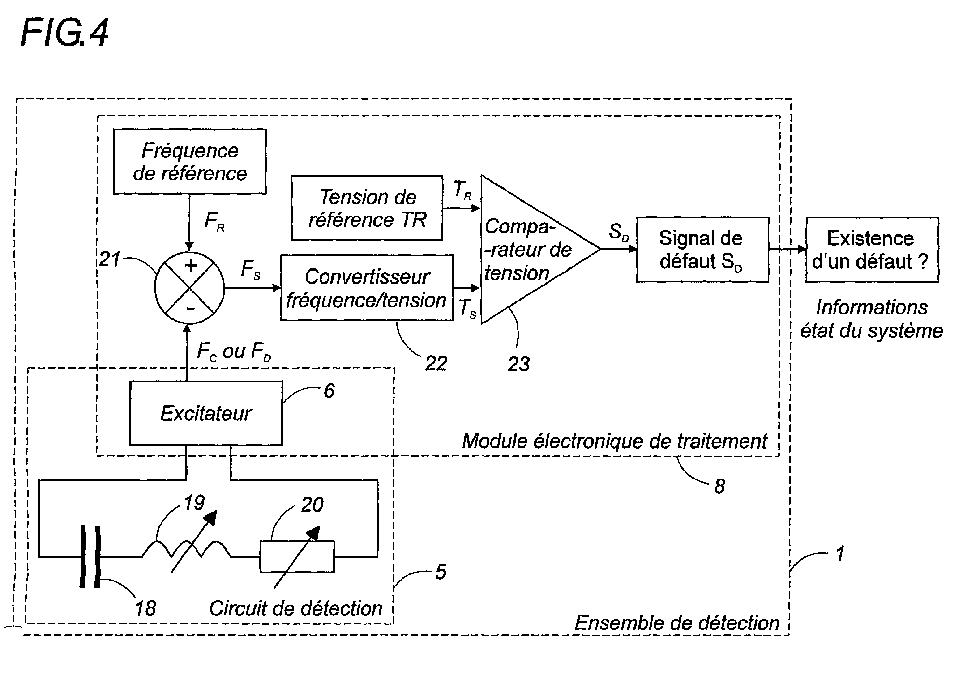

Un mode de réalisation préférentiel du module électronique de traitement 8 a été représenté sur le schéma électrique de la figure 4 et va maintenant être décrit.

Sur cette figure, le circuit de détection 5 a été symbolisé par un circuit RLC équivalent comportant, aux bornes de l'excitateur 6, un condensateur 18 fixe, une self 19 variable et une résistance 20 également variable, montés en série.

La self 19 et la résistance 20 ont été représentées variables car elles peuvent, comme expliqué précédemment, prendre deux valeurs différentes selon que le circuit de détection 5 comporte une branche 13 ou deux branches 12 et 13 en parallèle, c'est-à-dire selon que les contacts A et B se trouvent tous deux en contact ou non avec l'élément conducteur 4.

Le circuit de détection 5 présente donc en sortie une fréquence d'oscillation qui peut prendre, selon le cas, une valeur de contact F_{C} ou une valeur de décollement F_{D}.

La sortie de l'excitateur 6 à la fréquence de contact F_{C} ou de décollement F_{D} alimente un mélangeur 21 dont l'autre entrée reçoit une fréquence de référence F_{R} et duquel ressort un signal périodique à la fréquence de sortie F_{S} plus faible, représentant la différence entre les deux fréquences d'entrée.

On peut aussi, au préalable ou ensuite, diviser la fréquence d'entrée du mélangeur par un nombre important (par exemple 1000) afin de pouvoir utiliser des composants classiques du commerce.

Le signal sinusoïdal à la fréquence différentielle de sortie F_{S} attaque ensuite un convertisseur fréquence/tension 22 qui transforme la fréquence de sortie F_{S} en tension de sortie T_{S}.

La tension de sortie T_{S} est comparée à une tension de référence T_{R} dans un comparateur de tension 23 duquel ressort un signal de défaut S_{D} pouvant être exploité par la suite, par exemple dans un système de surveillance extérieur.

La différence entre la fréquence F_{C} d'oscillation du circuit résonnant en situation normale de contact et la fréquence F_{D} d'oscillation du circuit résonnant en cas de discontinuité électrique est importante. Elle est de préférence au moins de 20 %, ce qui permet après mélange, conversion en tension et comparaison, d'obtenir un signal de défaut S_{D} franc et significatif, permettant une exploitation ultérieure.

L'ensemble du circuit est préférentiellement accordé pour que lors du contact électrique simultané par les deux contacts 2 et 3, la fréquence F_{C} d'oscillation du circuit résonnant corresponde, après passage dans la chaîne de détection, à une tension insuffisante pour provoquer la naissance d'un signal de défaut S_{D} exploitable.

Afin d'illustrer plus complètement l'invention, un exemple préférentiel mais non limitatif d'application de l'invention a été représenté sur la figure 5.

Dans cette application, il s'agit de détecter le soulèvement d'un ou de deux patins frotteurs 24 et 25 coulissant le long d'un rail métallique de guidage 26 avec lequel ils doivent rester en contact.

Ces patins 24 et 25 appartiennent au système de guidage d'un véhicule autoguidé de transport en commun. Il peut s'agir indifféremment de patins de masse électrique ou de patins de retour de courant.

Un ensemble de détection 1 selon l'invention peut être monté sur ces patins 24, 25 et embarqué sur le véhicule.

Selon un mode de réalisation préférentiel de l'ensemble de détection 1, il peut être logé dans un boîtier compact pouvant se monter au-dessus des patins 24 et 25 dans un corps coulissant sur le rail de guidage.

L'ensemble de détection 1 selon l'invention fonctionne de la même façon que précédemment, les patins 24 et 25 servant respectivement de contact A et B et le rail métallique de guidage 26 remplaçant l'élément conducteur 4.

Le véhicule fournit l'énergie nécessaire au fonctionnement de l'ensemble de détection 1 qui reste cependant isolé du véhicule par le moyen d'isolation galvanique 7.

La liaison constructive 11 formant la deuxième branche 13 du circuit de détection 5 est assurée par l'intermédiaire de la caisse du véhicule dans le cas de patins de masse électrique ou par une connexion mutuelle en toiture pour les patins de retour de courant.

Le module électronique de traitement 8 transmet en temps réel une information sur l'état de l'ensemble de détection 1 au système général assurant la gestion centrale du véhicule et la sécurité du transport, qui peut le cas échéant, déclencher des actions préventives de sécurité, telles qu'un freinage d'urgence par exemple, lorsqu'un défaut est signalé.

Avantageusement, l'ensemble de détection 1 selon l'invention permet de détecter le décollement de chacun des patins 24 ou 25, indépendamment de l'état de l'autre. Il n'est donc pas nécessaire que les deux patins soient décollés pour que l'ensemble détecte un défaut. De même, l'ensemble de détection peut détecter une interruption du circuit électrique entre les deux patins 24 et 25, c'est-à-dire un défaut de la portion du rail de guidage 26 située entre ceux-ci.

Avantageusement, chaque patin faisant partie de l'ensemble de guidage peut se trouver deux à deux dans un circuit de détection 5 selon l'invention. Le signal de défaut résultant sera alors différent selon le couple de patins hors contact, ce qui permet une localisation automatique et immédiate du problème.

De manière évidente, l'invention ne se limite pas aux modes de réalisation préférentiels décrits précédemment et représentés sur les différentes figures, l'homme du métier pouvant y apporter diverses modifications évidentes restant dans le cadre des revendications.

## Revendications

1. Ensemble de détection (1) d'une discontinuité électrique entre un contact électrique (2, 3) et un élément électriquement conducteur (4), ensemble comprenant deux contacts électriques distincts (2, 3) et un élément électriquement conducteur (4) les reliant avec lequel les contacts électriques se trouvent normalement en contact, **caractérisé**
**en ce qu'**il comprend un excitateur (6) comportant comme charge un circuit résonnant, ce circuit résonnant comprenant en partant d'une des bornes de l'excitateur (6) pour revenir à son autre borne, au moins un condensateur (10), l'un des contacts électriques (2, 3), une partie d'impédance variable selon l'état ouvert ou fermé d'au moins l'un des contacts (2, 3) et le deuxième contact électrique (2,3) ;
**en ce que** la partie d'impédance variable comprend, en situation normale de contact, une première branche (12) résistive et selfique formée par l'élément conducteur (4) et au moins une deuxième branche (13) résistive et selfique, montée en parallèle et formée par une liaison électrique constructive (11) reliant les deux contacts (2, 3) ; la première branche (12) étant mise hors circuit à l'ouverture d'au moins l'un des contacts (2, 3) ;
et **en ce qu'**il comporte en outre un module électronique de traitement (8) qui reçoit la fréquence d'oscillation du circuit résonnant et la convertit en un signal de défaut exploitable en cas de discontinuité électrique.

2. Ensemble de détection selon la revendication 1, **caractérisé en ce qu'**il comprend un condensateur (10) intercalé entre chaque borne de l'excitateur (6) et le contact électrique (2, 3) correspondant.

3. Ensemble de détection selon l'une quelconque des revendications précédentes, **caractérisé en ce qu'**au moins une branche supplémentaire comprenant une résistance, une self ou les deux composants montés en série, est montée en parallèle sur la première branche (12) ou sur la deuxième branche (13).

4. Ensemble de détection selon l'une quelconque des revendications précédentes, **caractérisé en ce qu'**il est isolé par un moyen d'isolation galvanique (7).

5. Ensemble de détection selon l'une quelconque des revendications précédentes, **caractérisé en ce que** la différence entre la fréquence F_{C} d'oscillation du circuit résonnant en situation normale de contact et la fréquence F_{D} d'oscillation du circuit résonnant en cas de discontinuité électrique est supérieure ou égale à 20%.

6. Ensemble de détection selon l'une quelconque des revendications précédentes, **caractérisé en ce que** le module électronique de traitement (8) comprend un mélangeur (21) recevant la fréquence d'oscillation du circuit résonnant et une fréquence de référence F_{R}, le mélangeur (21) étant relié à un convertisseur fréquence/tension (22) dont la sortie est branchée à un comparateur (23) recevant une tension de référence T_{R}, pour l'émission d'un signal de défaut S_{D} en cas de discontinuité électrique, celle-ci se traduisant par une variation de fréquence d'oscillation du circuit résonnant.

7. Ensemble de détection selon la revendication précédente, **caractérisé en ce que** la fréquence d'entrée du mélangeur (21) est divisée afin d'utiliser des composants classiques du commerce.

8. Ensemble de détection selon l'une quelconque des revendications précédentes, **caractérisé en ce que** l'ensemble du circuit est accordé pour qu'en situation normale de contact, la fréquence F_{C} d'oscillation du circuit résonnant soit convertie après passage dans le module électronique de traitement (8) en une tension insuffisante pour provoquer la naissance d'un signal de défaut S_{D} exploitable.

9. Ensemble de détection selon l'une quelconque des revendications précédentes, **caractérisé en ce que** l'élément électriquement conducteur (4) est une masse, un profilé ou un revêtement métallique, ou une liaison électrique filaire reliant deux zones réceptrices conductrices destinées à recevoir les contacts (2, 3).

10. Ensemble de détection selon l'une quelconque des revendications précédentes, **caractérisé en ce que** la liaison constructive (11) est une liaison électrique structurelle ou une liaison électrique spécifique.

11. Ensemble de détection selon l'une quelconque des revendications précédentes, **caractérisé en ce que** les contacts (2, 3) sont mobiles sur l'élément électriquement conducteur (4).

12. Ensemble de détection selon la revendication précédente, **caractérisé en ce que** l'élément électriquement conducteur (4) est un rail métallique de guidage (26) ou de roulage et **en ce que** les contacts (2, 3) sont des patins (24, 25) coulissant le long du rail métallique de guidage (26) ou de roulage.

13. Ensemble de détection selon la revendication précédente, **caractérisé en ce qu'**il est logé dans un boîtier compact monté au-dessus des patins (24, 25) dans un corps coulissant le long du rail de guidage (26).

14. Ensemble de détection selon la revendication 12 ou 13 **caractérisé en ce que** les patins (24, 25) sont des patins de masse électrique ou des patins de retour de courant.

15. Ensemble de détection selon l'une quelconque des revendications 12 à 14, **caractérisé en ce qu'**il est embarqué sur un véhicule de transport en commun autoguidé et alimenté par le véhicule.

## Claims

1. An assembly (1) for detecting electric discontinuity between an electric contact (2, 3) and an electrically conducting member (4), which assembly comprises two distinct electric contacts (2, 3) and an electrically conducting member (4) connecting them with which the electric contacts are normally in contact, **characterized**
**in that** it comprises an exciter (6) comprising a resonating circuit as a charge, said resonating circuit comprising from one of the terminals of the exciter (6) to return to its other terminal, at least one capacitor (10), one of the electric contacts (2, 3), a portion with variable impedance depending upon whether at least one of the contacts (2, 3) is open or closed, and the second electric contact (2, 3);
**in that** the variable impedance portion comprises, in a normal contact situation, a first resistive and self-inductive branch (12) formed of the conducting member (4) and at least one second resistive and self-inductive branch (13) connected in parallel and formed of a constructive electric connection (11) joining the two contacts (2, 3); the first branch (12) being placed outside the circuit when at least one of the contacts (2, 3) opens;
and **in that** it further comprises an electronic processing module (8) which receives the oscillation frequency of the resonating circuit and converts it into a fault signal that can be used if there is an electric discontinuity.

2. A detection assembly according to claim 1 **characterized in that** it comprises a capacitor (10) interposed between each terminal of the exciter (6) and the corresponding electric contact (2, 3).

3. A detection assembly according to any one of the preceding claims **characterized in that** at least one supplemental branch comprising a resistor, a self-inductor, or both components connected in series, is connected in parallel on the first branch (12) or on the second branch (13).

4. A detection assembly according to any one of the preceding claims **characterized in that** it is insulated by a galvanic insulation means (7).

5. A detection assembly according to any one of the preceding claims **characterized in that** the difference between the oscillation frequency F_{C} of the resonating circuit in a normal contact situation and the oscillation frequency F_{D} of the resonating circuit if there is electric discontinuity is greater than or equal to 20%.

6. A detection assembly according to any one of the preceding claims **characterized in that** the electronic processing module (8) comprises a mixer (21) that receives the oscillation frequency of the resonating circuit and a reference frequency F_{R}, said mixer (21) being connected to a frequency/voltage converter (22) with its output joined to a comparator (23) receiving a reference voltage T_{R}, in order to emit a fault signal S_{D} if there is an electric discontinuity, the discontinuity being translated by an oscillation frequency variation in the resonating circuit.

7. A detection assembly according to the preceding claim **characterized in that** the input frequency of the mixer (21) is divided in order to use conventional business components.

8. A detection assembly according to any one of the preceding claims **characterized in that** the circuit assembly is tuned so that in a normal contact situation, the oscillation frequency F_{C} of the resonating circuit is converted, after passing into the electronic processing module (8), into a voltage that is insufficient to give rise to a useful fault signal S_{D}.

9. A detection assembly according to any one of the preceding claims **characterized in that** the electrically conducting member (4) is a metal mass, profile, or coating, or an electric wire joining two conductive receptor zones designed to receive the contacts (2, 3).

10. A detection assembly according to any one of the preceding clams **characterized in that** the constructive connection (11) is a structural electric connection or a specific electric connection.

11. A detection assembly according to any one of the preceding claims **characterized in that** the contacts (2, 3) move along the electrically conducting member (4).

12. A detection assembly according to the preceding claim **characterized in that** the electrically conducting member (4) is a metal guide rail (26) or travel rail and **in that** the contacts (2, 3) are shoes (24, 25) sliding along the metal guide rail (26) or travel rail.

13. A detection assembly according to the preceding claim **characterized in that** it is located inside a compact housing mounted above the shoes (24, 25) in an element that slides along the guide rail (26).

14. A detection assembly according to claim 12 or 13 **characterized in that** the shoes (24, 25) are electric mass shoes or current return shoes.

15. A detection assembly according to any one of claims 12 through 14, **characterized in that** it is attached to a guided public transport vehicle and supplied with energy by the vehicle.

## Patentansprüche

1. Anordnung zur Detektion (1) von einer elektrischen Diskontinuität zwischen einem elektrischen Kontakt (2, 3) und einem elektrisch leitfähigen Element (4), wobei diese Anordnung zwei unterschiedliche elektrische Kontakte (2, 3) und ein elektrisch leitfähiges Element (4) umfasst, das diese mit jenem verbindet, mit dem sich die elektrischen Kontakte normalerweise in Kontakt befinden, **gekennzeichnet dadurch, dass** sie einen Erreger (6) umfasst, der als Ladung einen Resonanzkreis umfasst, wobei dieser Resonanzkreis, ausgehend von einer der Anschlussklemmen des Erregers (6), um zu deren anderen Anschlussklemme zurückzuführen, mindestens einen Kondensator (10) aufweist, einen der elektrischen Kontakte (2, 3), ein Impedanzteil, das je nach dem offenen oder geschlossenen Zustand von mindestens einem der Kontakte (2, 3) variabel ist und den zweiten elektrischen Kontakt (2,3);
**dadurch**, dass das variable Impedanzteil in normaler Kontaktsituation einen ersten resistiven und induktiven Anschluss (12) umfasst, der aus dem elektrisch leitfähigen Element (4) und mindestens einen zweiten resistiven und induktiven Anschluss (13) besteht, der parallel montiert und durch eine konstruktive elektrische Verbindung (11) gebildet ist, die die beiden Kontakte (2, 3) miteinander verbindet, wobei der erste Anschluss (12) bei Öffnung von mindestens einem der Kontakte (2, 3) abgeschaltet ist, und **dadurch**, dass sie außerdem ein elektronisches Verarbeitungsmodul (8) umfasst, das die Schwingungsfrequenz des Resonanzkreises empfängt und sie bei Diskontinuität in ein verwertbares elektrisches Fehlersignal umwandelt.

2. Detektionsanordnung nach Anspruch 1, **gekennzeichnet dadurch, dass** diese einen Kondensator (10) umfasst, der zwischen jede Klemme des Erregers (6) und dem entsprechenden elektrischen Kontakt (2, 3) eingebracht ist.

3. Detektionsanordnung nach einem beliebigen der vorangehenden Ansprüche, **gekennzeichnet dadurch, dass** mindestens ein zusätzlicher Anschluss einen Widerstand, eine Drosselspule oder die beiden in Reihe angeordneten Komponenten parallel auf dem ersten Anschluss (12) oder auf dem zweiten Anschluss (13) montiert sind.

4. Detektionsanordnung nach einem beliebigen der vorangehenden Ansprüche, **gekennzeichnet dadurch, dass** diese durch ein galvanisches Isolierungsmittel (7) isoliert ist.

5. Detektionsanordnung nach einem beliebigen der vorangehenden Ansprüche, **gekennzeichnet dadurch, dass** der Unterschied zwischen der Schwingungsfrequenz F_{C} des Resonanzkreises in der normalen Kontaktsituation und der Schwingungsfrequenz F_{D} des elektrischen Resonanzkreises bei elektrischer Diskontinuität höher oder gleich 20% ist.

6. Detektionsanordnung nach einem beliebigen der vorangehenden Ansprüche, **gekennzeichnet dadurch, dass** das elektronische Verarbeitungsmodul (8) einen Mischer (21) umfasst, der die Schwingungsfrequenz des Resonanzkreises empfängt, und eine Bezugsfrequenz F_{R}, wobei der Mischer (21) an einen Frequenz-/Spannungs-Umrichter (22) angeschlossen ist, dessen Ausgang an einen Komparator (23) angeschlossen ist, der eine Bezugsspannung T_{R} empfängt, für die Ausgabe eines Signals 30 von einem Fehler S_{D} bei elektrischer Diskontinuität, wobei sich letztere durch eine Schwingungsfrequenz-Variation des Resonanzkreises auswirkt.

7. Detektionsanordnung nach dem vorangehenden Anspruch, **gekennzeichnet dadurch, dass** die Eingangs-Frequenz des Mischers (21) eingeteilt ist, um klassische Komponenten aus dem Handel zu benutzen.

8. Detektionsanordnung nach einem beliebigen der vorangehenden Ansprüche, **gekennzeichnet dadurch, dass** die Schaltungsanordnung so bemessen ist, dass die Schwingungsfrequenz F_{C} des Resonanzkreises in der normalen Kontaktsituation entweder nach Durchgang ins elektronische Verarbeitungsmodul (8) in eine ungenügende Spannung umgewandelt wird, um das Entstehen eines nutzbaren Fehlersignals S_{D} zu bewirken.

9. Detektionsanordnung nach einem beliebigen der vorangehenden Ansprüche, **gekennzeichnet dadurch, dass** das elektrisch leitfähige Element (4) eine Masse, ein Profilstück oder eine metallische Beschichtung, oder eine elektrische Kabelverbindung ist, die zwei leitfähige Empfangsbereiche verbindet, die dazu bestimmt sind, die Kontakte (2, 3) zu empfangen.

10. Detektionsanordnung nach einem beliebigen der vorangehenden Ansprüche, **gekennzeichnet dadurch, dass** die konstruktive Verbindung (11) eine strukturelle elektrische Verbindung oder eine spezifische elektrische Verbindung ist.

11. Detektionsanordnung nach einem beliebigen der vorangehenden Ansprüche, **gekennzeichnet dadurch, dass** die Kontakte (2, 3) auf dem elektrisch leitfähigen Element (4) beweglich sind.

12. Detektionsanordnung nach dem vorangehenden Anspruch, **gekennzeichnet dadurch, dass** das elektrische Leitelement (4) eine metallische Führungs- oder Rollschiene (26) ist, sowie **dadurch**, dass die Kontakte (2, 3) Gleitplatten (24, 25) sind, die entlang der metallischen Führungs- oder Rollschiene (26) gleiten.

13. Detektionsanordnung nach dem vorangehenden Anspruch, **gekennzeichnet dadurch, dass** diese in einem oberhalb der Gleitplatten (24, 25) in einem Gleitkörper entlang der Führungsschiene (26) montierten kompakten Gehäuse untergebracht ist.

14. Detektionsanordnung nach Anspruch 12 oder 13 **gekennzeichnet dadurch, dass** die Gleitplatten (24, 25) elektrische Masse-Gleitplatten oder Stromrückleitungs-Gleitplatten sind.

15. Detektionsanordnung nach einem beliebigen der Patentansprüche 12 bis 14, **gekennzeichnet dadurch, dass** diese auf ein gemeinsames selbstgeführtes Transportfahrzeug geladen und von dem Fahrzeug gespeist wird.
